# EUROPEAN PATENT APPLICATION

(11) **EP 4 632 118 A1**
(43) Date of publication of application: **15.10.2025**
(21) Application number: 24169104.7
(22) Date of filing: 09.04.2024
(51) Int. Cl.: C30B 25/18, C30B 29/36, C30B 29/40

(54) **LAYERED SUBSTRATE, METHOD OF FABRICATION OF A LAYERED SUBSTRATE AND METHOD FOR GROWING AN EPITAXIAL LAYER WITH THE LAYERED SUBSTRATE**

(71) Applicant: SiCrystal GmbH, 90411 Nürnberg (DE)
(72) Inventor: Ecker, Bernhard, 90411 Nürnberg (DE); Klietz, Wenzel, 90411 Nürnberg (DE); Müller, Ralf, 90411 Nürnberg (DE); Schuh, Philiipp, 90411 Nürnberg (DE); Stockmeier, Matthias, 90411 Nürnberg (DE); Vogel, Michael, 90411 Nürnberg (DE)
(74) Representative: Grünecker Patent- und Rechtsanwälte PartG mbB

(57) **Abstract**

The present disclosure relates to a layered substrate for growing an epitaxial layer in a direction of growth (Y) in a reactor. The layered substrate comprises a monocrystalline growing layer (110) with a growing surface (112) for growing the epitaxial layer and an opposing heat spreader facing surface (114) for coupling the growing layer (110) to a heat spreader substrate (140). The layered substrate further comprises the heat spreader substrate (140) with a growing layer facing surface (144) for coupling to the heat spreader facing surface (114) and an opposing mounting surface (142) for mounting the heat spreader substrate (140) to the reactor, wherein the heat spreader substrate (140) comprises a polycrystalline material having thermally coupled grains (146) that are piled in the direction of growth (Y), the piled grains (146) for equalizing hot spots of the reactor thermally coupled to the mounting surface (142).

## Description

### TECHNICAL FIELD OF THE INVENTION

The present invention relates to a layered substrate, method of fabrication of a layered substrate and method for an epitaxial layer with the layered substrate.

### BACKGROUND OF THE INVENTION

Semiconductor materials such as silicon carbide (SiC) are commonly used in the manufacture of electronic components. SiC is a compound semiconductor that forms the basis for power electronic components, e.g. in the automotive and green energy sectors.

Using a suitable source material, the volume mono crystals are typically grown by sublimation growth as a physical vapor deposition (PVT) process. Substrates are then fabricated from the grown volume mono-crystals using e.g. multi-wire saws and the surface is then refined using multi-stage polishing steps. In a subsequent epitaxial process, thin single crystal layers (e.g. SiC, GaN) are deposited on the substrates. The properties of these layers and the devices fabricated from them depend crucially on the quality of the SiC substrate.

The basic principle of mono crystal growth is based on the sublimation of a starting material and the subsequent transport of the species in the gas phase (SiC, Si2C, SiC2) to a seed on which the material is deposited and the volume mono crystal grows. The quality of the seed is extremely important to ensure low defect density in the growing crystal. Substrates are then fabricated from the bulk mono crystals. Due to the increasing demand for high quality substrates for the production of electrical components, the use of high quality substrates for the epitaxial growth process is essential to grow crystals of the highest possible quality.

Several factors influence the growth of an epitaxial layer using an epitaxial process such as the chemical vapor deposition (CVD) process in a reactor. The factors discussed below are those that are particularly critical with respect to the CVD process. However, those skilled in the art will know that epitaxial processes may have the same or similar limitations. The epitaxial processes may be the Vapor Phase Epitaxy (VPE) process, wherein common types of VPE include metalorganic vapor phase epitaxy (MOVPE) and the CVD process, Molecular Beam Epitaxy (MBE), Liquid Phase Epitaxy (LPE), Hydride Vapor Phase Epitaxy (HVPE), .

Particularly in the present application, the temperature distribution within a process such as the CVD process is critical for controlling deposition of the epitaxial layer. The temperature distribution of the substrate determines the rate of vapor transport and deposition. Optimizing the temperature profile of the substrate helps to achieve uniform deposition of the epitaxial layer and minimize defects.

Other effects that have a major impact, for example on the CVD process, include
- the flow rates and compositions of precursor gases;
- the quality of the substrate surface before epitaxial growth;
- the rate at which the epitaxial layer is grown influences its crystalline quality and uniformity;
- the control of various process parameters such as pressure, gas flow rates, substrate temperature, and deposition rate; and
- the annealing processes performed after epitaxial growth.

In view of the above considerations, EP 4 074 870 proposes an asymmetric substrate to allow the growth of high quality epitaxial layers. However, this solution does not compensate for variations in the substrate temperature.

### SUMMARY OF THE INVENTION

The present invention has been made in view of the shortcomings and disadvantages of the prior art, and an object thereof is to provide an improved substrate coupling to the reactor which eliminates or at least mitigates the above disadvantages and shortcomings of the related prior art.

This object is solved by the subject matter of the independent claims. Advantageous embodiments of the present invention are the subject matter of the dependent claims.

In particular, the subject is solved by a layered substrate. The layered substrate comprises, in addition to the monocrystal growing layer, a heat spreading substrate comprising a polycrystalline material. This enables the growth of high quality epitaxial layers. Due to the temperature levelling effect of the multilayer substrate, growth inhomogeneities can be reduced. This increases the quality of the epitaxial layers and the electronic components produced from them. These epitaxial layers have reduced thermal stress and therefore improved geometry. These epitaxial layers also contain fewer impurities, dislocations, local polytype changes, and stacking defects.

A first aspect relates to layered substrate for growing an epitaxial layer in a direction of growth in a reactor. The layered substrate comprises a monocrystalline growing layer with a growing surface for growing the epitaxial layer and an opposing heat spreader facing surface for coupling the growing layer to a heat spreader substrate. Further, the layered substrate comprises the heat spreader substrate with an growing layer facing surface for coupling to the heat spreader facing surface and an opposing mounting surface for mounting the heat spreader substrate to the reactor, wherein the heat spreader substrate comprises a polycrystalline material having thermally coupled grains that are piled in the direction of growth, the piled grains for equalizing hot spots of the reactor thermally coupled to the mounting surface.

The first aspect facilitates to level a temperature profile with hot spots coupled in the layered substrate at the mounting surface so that that temperature profile at the growing surface is smoother thereby improving the quality of the epitaxial layer.

A second aspect relates to a substrate according to aspect 1, wherein the monocrystalline growing layer has a thickness in the direction of growth of equal to or greater than 10 µm and/or less than or equal to 100 µm, and/or wherein the heat spreader substrate has a thickness in the direction of growth of equal to or greater than 250 µm and/or less than or equal to 500 µm. Optionally the layered substrate has a diameter in a radial dimension of equal to or greater than 150 mm preferably 200 mm and/or less than or equal to 300 mm, the radial dimension is perpendicular to the direction of growth.

The second aspect facilitates to level a temperature profile by selecting appropriate parameter for thickness and diameter thereby improving the quality of the epitaxial layer.

A third aspect relates to substrate according to any of the proceeding aspects, wherein a median grain diameter, D50, is equal to or greater than 3 µm and/or less than or equal to 80 µm, preferably wherein D50 is equal to or greater than 3 µm and/or less than or equal to 50 µm, Optionally wherein a number of grains piled in the heat spreader substrate in the direction of growth is equal to or greater than 3 and/or less than or equal to 163, preferably wherein the number is equal to or greater than 5 and/or less than or equal to 163.

The third aspect facilitates to level a temperature profile by selecting a grain parameters thereby improving the quality of the epitaxial layer.

A fourth aspect relates to a substrate according to any of the proceeding aspects, wherein the monocrystalline growing layer comprises a first material, the first material being at least one of Si, SiC, AIN, GaN, AlGaN, AlInN, and InN, and/or the grains of the heat spreader substrate comprise a second material, the second material being at least one Si, SiC, AIN, GaN, Al2O3 , GaAs and oxide substrate. Optionally the second material is identical to the first material and the first material being at least one of Si, SiC, AIN, and GaN, or wherein the first material is different from the second material. Optionally the monocrystalline growing layer consists of the first material.

The fourth aspect facilitates to level a temperature profile by selecting a seed layer materials thereby improving the quality of the epitaxial layer.

A fifth aspect relates to a substrate to any of the proceeding aspects, wherein the heat spreader substrate comprises a third material, the third material being a metal, preferably, wherein the third material being at least one of Ti, Fe, W, Mo, and V.

The fifth aspect facilitates to level a temperature profile by adding impurities to the heat spreader substare thereby improving the quality of the epitaxial layer.

A sixth aspect relates to a substrate according to any of the proceeding aspects, wherein the grains of the heat spreader substrate comprise a second material and the heat spreader substrate comprises a third material, the third material having a higher a higher mass than the second material. Optionally the heat spreader layer comprises the third material at a grain boundary between abutting grains.

The sixth aspect facilitates to level a temperature profile for the same reasons as the fifth aspect, in particular by adding high mass impurities to the grain boundaries thereby improving the quality of the epitaxial layer.

A seventh aspect relates to a substrate according to any of the proceeding aspects, wherein the heat spreader substrate comprises a concentration of impurities, wherein the concentration is equal to or greater than 5 ppm, preferably 10 ppm and/or less than or equal to 1000 ppm.

The seventh aspect facilitates to level a temperature profile for the same reasons as the fifth and sixth aspect, in particular by adding certain amount of impurities to the heat spreader substrate thereby improving the quality of the epitaxial layer.

An eighth aspect relates to a substrate according to any of the proceeding aspects, wherein an angle between a crystallographic axis of the monocrystalline growing layer (110) and a surface normal of the growing surface (112) is equal to or greater than 0° and/or less than or equal to 8°, preferably the angle is equal to or greater than 2° and/or less than or equal to 6°.

The eighth aspect facilitates mitigate effects of a temperature profile by enabling step growth thereby improving the quality of the epitaxial layer.

A ninth aspect relates to a substrate according to any of the proceeding claims, wherein the growing surface comprises a silicon face, Si-face, preferably the growing surface is a Si-face.

The ninth aspect facilitates mitigate effects of a temperature profile by improving the growing using a Si-face thereby improving the quality of the epitaxial layer.

A tenth aspect relates to a substrate according to any of the proceeding claims, further comprising a connecting layer between the monocrystalline growing layer and the heat spreader substrate, wherein the connecting layer preferably comprises at least one of a phenolic resin, novolac resin, and sintered powder, preferably sintered silicon powder.

The tenth aspect facilitates to level the temperature profile by combining the multilayer substrate thereby improving the quality of the epitaxial layer.

An eleventh aspect relates to a method for fabricating a layered substrate for growing an epitaxial layer in a direction of growth in a reactor, the method comprises the steps of:
providing a monocrystalline growing layer with a growing surface for growing the epitaxial layer and an opposing heat spreader facing surface for coupling the growing layer to a heat spreader substrate; and
providing the heat spreader substrate with a growing layer facing surface for coupling to the heat spreader facing surface and an opposing mounting surface for mounting the heat spreader to the reactor,
wherein the heat spreader substrate comprises a polycrystalline material having thermally coupled that are piled in the direction of growth, the piled grains for equalizing hot spots of the reactor thermally coupled to the mounting surface,
connecting the growing layer facing surface to the heat spreader facing surface.

The eleventh aspect facilitates to level a temperature profile for the same reasons as the first to tenth aspect.

A twelfth aspect relates to a method according to aspect 11, wherein the growing layer facing surface is connected to the heat spreader facing surface by a at least one of a gluing step and a sintering step for forming a connecting layer between the monocrystalline growing layer and the heat spreader substrate.

The twelfth aspect facilitates to level a temperature profile by a uniform thermal coupling between the multiple layers thereby improving the quality of the epitaxial layer.

A thirteenth aspect relates to a method for growing an epitaxial layer in a direction of growth, the method comprising the steps of:
Mounting a layered substrate according to any of aspects 1 to 10 or a layered substrate fabricated according to the method of aspects 11 to 12 in a reactor,
Growing, by an epitaxy process, the epitaxial layer on the monocrystalline growing layer.

The thirteenth aspect facilitates improving the quality of the epitaxial layer by levelling a temperature profile for the same reasons as the first to twelfth aspect.

A fourteens aspect relates to a method according to aspect 13, wherein the mounting surface of the heat spreader substrate is mounted to the reactor.

The fourteens aspect facilitates improving the quality of the epitaxial layer by levelling a temperature profile for the same reasons as the first to twelfth aspect.

A fifteens aspect relates to a method according to any of aspects 13 to 14, wherein the epitaxial layer is grown by chemical vapor deposition, optionally wherein growing comprises heating the layered substrate to a temperature of equal to or greater than 1500°C and/or less than or equal to 2000°C.

The fifteens aspect facilitates improving the quality of the epitaxial layer by levelling a temperature profile for the same reasons as the first to twelfth aspect.

### BRIEF DESCRIPTION OF THE FIGURES

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:
- FIG. 1: is a schematic view of a layered seed according to an example;
- FIG. 2: is a further schematic side view of the layered seed according to an example;
- FIG. 3: a further schematic side view of the layered seed according to an example;
- FIG. 4: a schematic of growing an epitaxial layer on a growing layer of a substrate,; and
- FIG. 5: a schematic of growing an epitaxial layer on a growing layer of a substrate,.

### DETAILED DESCRIPTION

### Epitaxial growth

Epitaxial growth is a process that a crystalline layer of one material (the epitaxial layer) is grown on a crystalline substrate of another material (a growing surface of the substrate), maintaining a continuous crystal lattice structure between the two layers.

There are two main types of epitaxial growth, namely homoepitaxy and heteroepitaxy. In homoepitaxy, the epitaxial layer and the substrate are made of the same material. For example, growing a layer of silicon on a silicon substrate. In heteroepitaxy, the epitaxial layer and the substrate are made of different materials. For example, growing a layer of gallium arsenide (GaAs) on a silicon (Si) substrate.

The epitaxial growth process typically involves techniques such as CVD and MBE. In CVD, gases containing the desired atoms or molecules are introduced into a reactor where they react and deposit onto the growing surface of the substrate, forming the epitaxial layer. In MBE, individual atoms or molecules are precisely deposited onto the substrate surface in a high vacuum environment.

Epitaxial growth allows for the creation of thin films with controlled properties, such as electronic, optical, or magnetic characteristics. It is widely used in the semiconductor industry for manufacturing integrated circuits, LEDs, solar cells, and other electronic devices. The precise control over material properties and crystal structures afforded by epitaxial growth is essential for achieving high-performance devices with desired functionality.

An epitaxial step-flow model can describe the process of growing. In more detail, the epitaxial step-flow model is a theoretical framework used to describe the growth mechanism of thin epitaxial layers during the epitaxial growth process. It specifically focuses on the growth of thin layers through the interaction of atomic steps and terraces with incoming and depositing gaseous species on the substrate growing surface.

In the epitaxial step-flow model, the process begins with the nucleation of incoming and depositing gaseous species of material on the substrate surface.

Once nucleated, the steps and terraces grow through the addition of atoms or molecules from the vapor phase. At the atomic steps the atoms incorporate into the growing lattice. These steps propagate across the surface as atoms are added, advancing the growth front.

The epitaxial layer continues to grow as atoms are deposited onto the surface and incorporated into the crystal lattice. The layer maintains a continuous crystal structure, especially same polytype in SiC epitaxial growth, with the substrate, resulting in epitaxial growth.

### Temperature distribution

As discussed above, thermal gradients are critical to crystal quality. In particular, when growing an epitaxial layer using the CVD process, temperature gradients over the surface, which may be x and z direction perpendicular to the axis of grows, must be precisely controlled to produce high-quality epitaxial layers. Like the PVT process, the CVD process is also a high-temperature process that takes place at approx. 1500°C or even higher temperatures. High-purity gases fed into the reactor are deposited on the growing surface of the substrates placed in holders. The holder may rotate to level the temperature distribution in x and z direction.

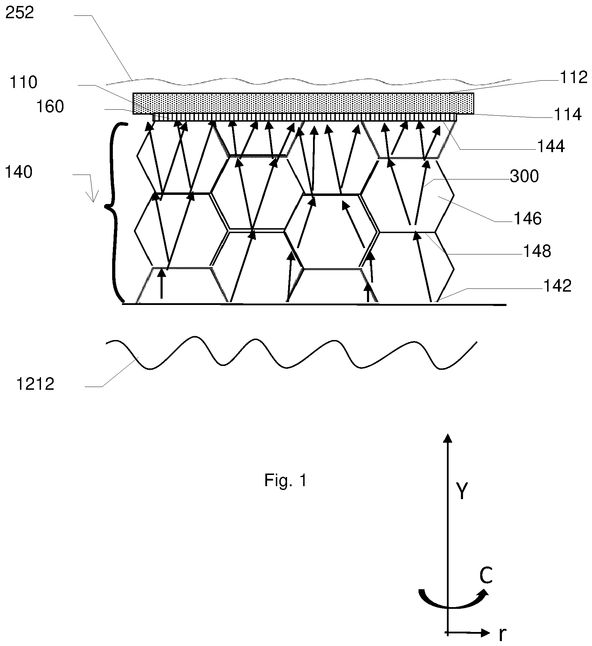

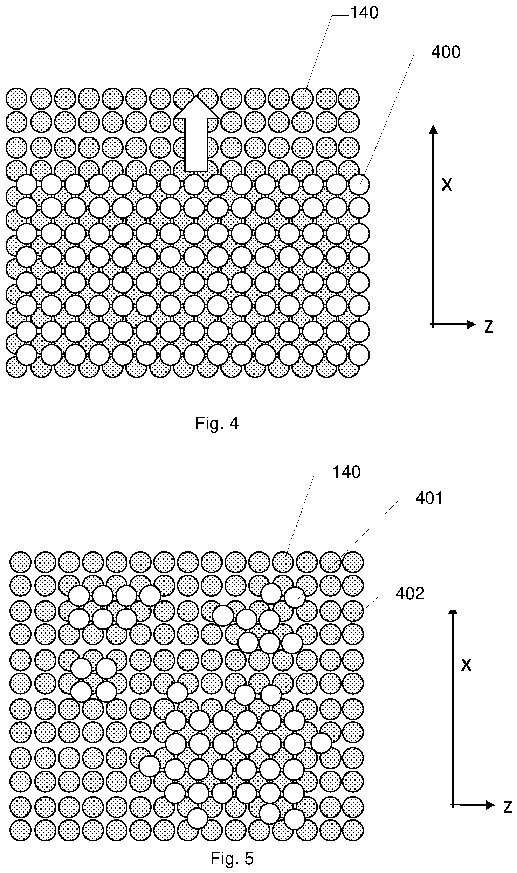

Ideally, as shown in FIG. 4, an epitaxial layer 400 has only one growing front on a growing layer 110 of the substrate. As shown in FIG. 4, a Cartesian coordinate system is used to describe the arrangement of crystal cells in the growing layer, i.e., they are arranged in a regular grid extending in a direction x and z. Perpendicular to the grid, the growing direction Y is arranged. The Cartesian coordinates x and z of FIGS. 4 and 5 are converted in FIGS. 1 to 3 to circular coordinates, namely the radial direction r and the circumferential direction C.

Thermal influences play a significant role in the nucleation process within the epitaxial step-flow model. Temperature affects the kinetics of adsorption, desorption, and surface diffusion of atoms or molecules on the substrate surface. Specifically, higher temperatures generally lead to increased mobility of atoms or molecules on the substrate surface, promoting the formation of larger nuclei and accelerating the nucleation rate. Further, the temperature also influences the density of nucleation sites on the substrate surface.

Thus, having a not uniform temperature distribution on the growing surface, locally interrupted island growth at epitaxial islands 401, 402 may occur as shown in FIG. 5. When the islands overgrow or grow together, stresses and resulting defects occur in the crystal lattice. The defects may comprise for example dislocations and stacking faults. This reduces the yield of the electrical components processed from them. For example, defects lead to higher leakage currents and the desired voltages and currents cannot be passed through the component, or they destroy the component.

### Further improvements

It has been observed that even a high-quality substrate, e.g. a substrate with low dislocation density and low bending, can lead to unexpectedly low quality when used in the subsequent epitaxy process, usually a type of CVD, in which one or more monocrystalline layers of the same or a different semiconductor (SiC on SiC, GaN on GaN, AIN on AIN or GaN or AIN on SiC or generally homo- or heterostructures) are deposited. AIN on SiC or homo- or heterostructures in general) can lead to an unexpectedly low quality of the grown layer.

So far, to the temperature distribution in the x and z plane discussed above in view of FIGS. 4 and 5, have been compensated for example by rotating the substrate and employ materials with high thermal conductivity and low thermal mass for substrate holders and chamber walls to minimize temperature gradients. Additionally, thermal insulation layers can be applied to chamber walls to reduce heat loss and improve temperature stability. Investigations have shown that thermal coupling of the substrate to the reactor can result in local deviations from the desired temperature field at a mounting surface that are conducted to a growing surface.

These local hot spots may increase the not wanted island growth shown in above FIG. 5.

In other words, the temperature distribution coupled to a mounting surface of the substrate affects the quality of the epitaxial layer. The technical problem to be solved is to optimize the temperature distribution at the growing surface of the substrate.

The inventors have therefore identified the possibility of providing an improved substrate, an improved fabrication method and an improved growing method to avoid one or more of the disadvantages described above. The present invention relates to various solutions and variants for such an improved seed.

### Solutions

In the following, different implementations and variants will be explained. The following disclosure was facilitated by the discussions and findings as described above and may for example be based at least on part thereof.

In general, it should be noted that many assumptions have been and are made herein so as to be able to explain the principles underlying the present disclosure in a clear, concise and understandable manner. These assumptions are however to be understood merely as examples made herein for illustration purposes, which are not necessarily essential for the invention and should thus not limit the scope of the disclosure. A skilled person will be aware that the principles of the following disclosure and as laid out in the claims can be applied to different scenarios and in ways that are not explicitly described herein.

For example, a **substrate** refers to a solid material onto which thin films, layers, or patterns of another material are deposited or grown. It serves as a foundation or base upon which further material deposition or fabrication processes take place. Substrates can be prepared with specific surface treatments, coatings, or patterns to optimize adhesion, promote nucleation, or control surface properties during subsequent deposition or fabrication processes. Additionally, substrates may undergo cleaning and preparation steps to remove contaminants and ensure a pristine surface for material growth or deposition.

Furthermore, an epitaxial layer is a thin crystalline film grown on the surface in a process called epitaxy described above. Epitaxy involves the deposition of atoms or molecules in a highly ordered manner, allowing the deposited material to adopt the crystal structure and orientation of the underlying substrate. Key characteristics of epitaxial layers include
- Crystal Structure: Epitaxial layers exhibit the same crystal structure as the substrate upon which they are grown. This ensures compatibility with the substrate and allows for seamless integration into device structures.
- Orientation: The orientation of the epitaxial layer's crystal lattice matches that of the substrate, resulting in a continuous and uniform lattice across the substrate surface.
- Thickness Control: Epitaxial growth techniques enable precise control over the thickness of the deposited layer, ranging from a few nanometers to several micrometers.
- Doping: Epitaxial layers can be doped with specific impurities to modify their electrical properties, such as carrier concentration and conductivity.
- Surface Smoothness: Epitaxial growth processes often result in smooth and defect-free surfaces, which are essential for high-performance semiconductor devices.

In addition, a **heat spreader** is a component used to more effectively and uniformly dissipate heat across a surface. It's designed to transfer heat away from heat-generating components, such as a heater close to an end wall, coupled to a mounting surface of the substrate and distribute it over a growing layer facing surface, thereby reducing localized hot spots on the end wall.

A **polycrystalline material** is a type of solid material composed of multiple crystalline grains. Each grain within the material has its own crystal structure, orientation, and lattice arrangement. These grains are typically randomly oriented with respect to each other, forming boundaries known as grain boundaries.

Unlike single crystal materials, where the entire structure consists of a continuous lattice with no grain boundaries, polycrystalline materials have distinct grains separated by these grain boundaries. Each grain may have slightly different physical and chemical properties due to variations in crystal orientation, defects, impurities, or processing conditions.

Further, **piled grains** is used herein to describe a plurality of grains placed on top of each other in a disorderly or haphazard manner to form a layer. The arrangement may be irregular and the objects may not be neatly aligned.

A **layer** is a specific thin structure that can be deposited on another structure or layer. A layer can be made up of different materials and have specific functions, such as growing structures, connecting other layers, or dissipating heat.

### First solution - layered substrate

FIG. 1 shows a layered substrate for growing an epitaxial layer by epitaxial growth in a direction of growth Y in a reactor according to an example according to a general solution. In particular, the layered substrate comprises a monocrystalline growing layer 110 and a heat spreader substrate 140.

The a monocrystalline growing layer 110 has a growing surface 112 for growing the epitaxial layer and an opposite heat spreader facing surface 114 for coupling the growing layer 110 to the heat spreader substrate 140.

The heat spreader substrate 140 has a growing layer facing surface 144 for coupling to the heat spreader facing surface 114 and an opposing mounting surface 142 for mounting the heat spreader substrate to the reactor. Thermal coupling refers to the process by which two or more objects or systems come into contact with each other and exchange thermal energy. When objects are thermally coupled, heat can flow between them due to a temperature difference, leading to a change in temperature in one or both of the objects until they reach thermal equilibrium, where their temperatures are equal.

The heat spreader substrate 140 comprises a polycrystalline material having a plurality of thermally coupled grains 146 that are piled in the direction of growth Y. As shown in FIG. 1, abutting piled grains 146 are separated by grain boundaries 148.

Also shown in Figure 1 are phonons 300. A phonon is a quasiparticle in a crystalline lattice of atoms or molecules that represents the vibrational energy of the lattice. In simpler terms, a phonon is a unit of vibrational energy that propagates through a solid material in much the same way that a photon carries energy in a wave. Phonons carry thermal energy through a material by transferring vibrational energy from one atom to another.

At a grain boundary 148, which, as described above, is the interface between two adjacent crystalline grains 146 in the polycrystalline heat spreader substrate 140, the behavior of phonons 300 differs from their behavior within the grain 146. In particular, phonons 300 may be scattered at grain boundaries 148, resulting in phonon reflection, transmission, or conversion to other types of vibrational modes.

Given the plurality of piled grains 146, the piled grains 146 equalize hot spots in the temperature profile 1212 of the reactor thermally coupled to the mounting surface 142 into a balanced temperature profile 252. Notably, FIG. 1 shows the temperature profile without any global temperature profile.

In other words, the use of a polycrystalline layer, e.g. a polycrystalline SiC layer, in combination with a monocrystalline layer, e.g. a monocrystalline SiC layer, as a layered substrate, i.e. a layered substrate, has the advantage that thermal inhomogeneities 1212 are compensated by the grain boundaries 148 in the polycrystalline substrate 140.

These inhomogeneities 1212, which may originate from inhomogeneities of the materials used for the end wall or an optional substrate holder and the epitaxial growth reactor, e.g. graphite, as a result of which the heat does not reach the growth layer 110 uniformly. The thermal coupling of the substrate to the end wall or an optional substrate holder may also be negatively affected by unwanted thermal contacts or contact losses, e.g. due to the different thermal expansion of the materials used in the crucible.

The mechanism for thermal levelling takes place via heat dissipation at the internal grain boundaries 148 of the polycrystalline substrate, e.g. a SiC wafer. The number of grains 146 and the resulting grain boundaries 148 to be crossed in the polycrystalline layer 140 result in a homogeneous temperature field for the subsequent monocrystalline layer 110, e.g., a monocrystalline SiC layer.

### First implementation - dimensions of the substrate layers

According to an implementation of the first solution, various dimensions of the substrate can be considered. In more detail, as discussed above, the layered substrate comprises substrate layers where the thickness is small compared to the diameter. The thickness of the substrate layers is measured here in the direction of growth Y. The diameter of the layers is measured in the radial direction r. The radial dimension is perpendicular to the direction of growth Y.

The thickness of the layered substrate can influence several aspects of the epitaxial growth process and the resulting epitaxial layer. For example, thicker substrates tend to provide a more stable base for epitaxial growth, resulting in better thickness uniformity across the deposited layer. Thin substrates may exhibit more variation in thickness due to surface irregularities or fluctuations in growth conditions. Further, thicker substrates can better accommodate strain induced by lattice mismatches between the epitaxial layer and the substrate material. Thinner substrates may experience greater strain, which could lead to defects or dislocations in the epitaxial layer. The thickness of the substrate can affect the growth rate and nucleation behavior of the epitaxial layer. Thicker substrates may require longer deposition times to achieve the desired thickness, while thinner substrates may reach the desired thickness more quickly. Further, thicker substrates may exhibit different thermal properties, such as thermal conductivity and heat capacity, compared to thinner substrates. These thermal properties can influence temperature distribution and thermal stability during the epitaxial growth process. Finally, thicker substrates typically require more material and may be more expensive to manufacture compared to thinner substrates. Additionally, thicker substrates may result in higher material wastage during the epitaxial growth process.

The total thickness of the polycrystalline substrate 140 and monocrystalline layer 110 together can between 350 µm and 500 µm.

For example, the thickness of the monocrystalline growing layer 110 can range from a few ten micrometers to several hundred micrometers, depending on the application. Thinner growing layers may be used for certain applications where precise control over crystal orientation or morphology is required, while thicker growing layers may be preferred for larger-scale production or to accommodate specific growth conditions. Preferably, the thickness of the growing layer 110 is equal to or greater than 10 µm. Additionally or alternatively, the thickness of the growing layer 110 is less than or equal to 100 µm.

Furthermore, in view of the considerations of the layered substrate, the optimum thickness of the heat spreader substrate in the growth direction Y of the same can be greater than 250 µm. Additionally or alternatively, the thickness of the heat spreader substrate can be less than or equal to 500 µm, preferably less than or equal to 490 µm.

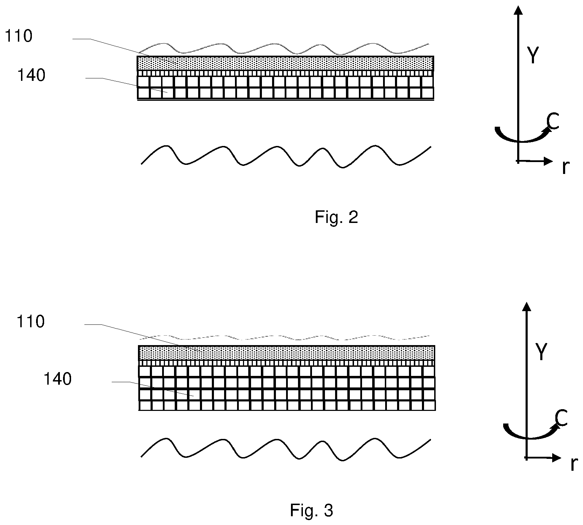

FIG. 2 shows a layered substrate with a heat spreader substrate 140 that is thin compared to the heat spreader substrate 140 in the layered seed shown in FIG. 3. Notably, FIGS. 2 and 3 show the temperature profile without a global temperature profile. In particular, in contrast to PVT growth in Epi reactors, it is aimed for highly homogeneous temperature profiles. As this is in particular not possible, for example where the substrate is mounted, a need for the heat spreader exists.

In other words, the leveling effect of the heat spreader substrate is proportional to the thickness of the heat spreader substrate. Consequently, a thicker substrate will increase the leveling effect. However, as discussed above, a temperature profile can couple to the layered substrate to modify the temperature profile, e.g. for compensating coupling effects of an end wall an optional holder. Therefore, the thickness can be limited to allow to propagate the temperature profile.

Further, the layered substrate can have a diameter in a radial dimension r, of equal to or greater than 150 mm, preferably equal to or greater than 200 mm and/or less than or equal to 300 mm.

The thickness and/or diameter values are particularly applicable to a heat spreader substrate containing or consisting of SiC.

### Second implementation - dimensions of the grains

According to a second implementation of the first solution, in addition or alternatively to the thicknesses of the heat spreader substrate 140 described in the first implementation, parameters relating to the grains 146 in the polycrystalline layer can be used as another control variable. The median grain size (D50) in polycrystalline materials refers to the size of the grains in the microstructure of the material, where half of the grains are smaller and half are larger than the median grain size. The influence of median grain size on polycrystalline materials is significant and affects various mechanical, thermal, electrical and optical properties.

For example, as discussed above, the presence of grain boundaries 148 can impede the propagation of phonons, thereby reducing the thermal conductivity of the material. A smaller D50 will typically result in more grain boundaries, leading to a higher leveling effect.

In addition, a smaller D50 tends to improve the mechanical properties of polycrystalline materials. This is because smaller grains create more grain boundaries, which act as barriers to dislocation motion and increase the strength and hardness of the material. However, excessively small grains can also result in reduced ductility and toughness.

In particular, D50 can be equal to or greater than 3 µm. Additionally or alternatively, D50 may be less than or equal to 80 µm. Preferably, D50 is less than or equal to 50 µm. The D50 values are particularly applicable to a heat spreader substrate comprising or consisting of SiC.

For example, given the above parameters for thickness between 250 µm and 490 µm and a D50 between 3 µm and 80 µm, the number of grains piled in the growth direction Y in the heat spreader substrate is equal to or greater than 3 and/or less than or equal to 163. Preferably, the number of grains piled in the growth direction Y in the heat spreader substrate is equal to or greater than 5.

### Third implementation - dimensions of the grains

The above description is mainly based on the assumption that the monocrystalline growth layer and the heat spreader substrate are made of SiC. According to a third implementation, alternative materials can be used to produce high quality epitaxial layers. The heat spreader substrate and the monocrystalline growing layer of the layered substrate can form a homostructure or a heterostructure. The main difference between a homostructure and a heterostructure is the composition of the semiconductor materials within the layered substrate. Homostructures consist of layers of the same semiconductor material, while heterostructures consist of layers of different semiconductor materials. Each type of structure offers distinct advantages and is used in different semiconductor devices depending on the desired properties and functionality.

For example, homostructures are commonly used in devices such as bipolar junction transistors (BJTs) or metal-oxide-semiconductor field-effect transistors (MOSFETs), where device characteristics are optimized by adjusting the doping concentration or thickness of the same semiconductor material. Heterostructures enable the creation of novel electronic and optoelectronic devices with enhanced functionality, such as improved carrier confinement, bandgap engineering, and increased electron mobility.

The above description is mainly based on the assumption that the monocrystalline growing layer and the heat spreader substrate comprise SiC. Alternative materials can be used for the production of high-quality epitaxial layers. The heat spreader substrate and the monocrystalline growing layer of the layered substrate can form a homo- or a heterostructure.

For example, the monocrystalline growing layer may comprise or consist of a first material, wherein the first material is at least one of Si, SiC, AIN, GaN, AlGaN, AlInN, and InN.

Additionally or alternatively, the grains of the heat spreader substrate comprise or consist of a second material, wherein the second material is at least one of Si, SiC, AIN, GaN, Al2O3, GaAs, and oxide substrate. An oxide substrate refers to a material, typically a crystalline structure, composed primarily of oxides. Oxides are chemical compounds containing at least one oxygen atom and one other element.

As discussed above, for a homostructure, the second material is identical to the first material. For example, the homostructure material can be at least one of Si, SiC, AIN, and GaN.

As discussed above, for a heterostructure, the first material is different from the second material. For example, the heat spreader substrate can comprise SiC and the monocrystalline growing layer can comprise any of Si, AIN, GaN, AlGaN, AlInN, and InN.

Polycrystalline SiC can be used as heat spreader forming a heterostructure with monocrystalline AIN for improved growth of AIN monocrystals, having a low lattice constant mismatch. Advantageously, polycrystalline Si can be used as cheap and easily accessible heat spreader in conjunction with a SiC monocrystalline layer to improve SiC monocrystal growth.

Notably, the monocrystalline growing layer can consist of the first material or may comprise the first material and some dopant atoms. Similarly, the heat spreader substrate growing layer can consists of the second material or may comprise the second material and some impurities. These dopant atoms and impurities may not be considered in defining that the seed layer is a homostructure.

### Fourth implementation - Impurities

According to a fourth implementation of the first solution, additional elemental impurities may be introduced in the polycrystalline layer. This may happen during the formation of the polycrystalline heat spreader substrate. For example, the impurities accumulate at the grain boundaries due to grain boundary segregation. Grain boundary segregation refers to the phenomenon in which certain atoms or molecules preferentially accumulate or segregate at the boundaries between grains in a polycrystalline material. These impurities, also referred to as foreign atoms, that accumulate at the grain boundaries can act as more effective scattering centers for the phonons than the grain boundaries themselves due to their comparatively higher mass.

The heat spreader substrate comprises for example a concentration of impurities, wherein the concentrations are equal to or greater than 5 ppm, preferably10 ppm and/or less than or equal to 1000 ppm.

For example, the grains of the heat spreader substrate can comprise a second material, for example the materials described above, e.g. Si, SiC, AIN, GaN, Al2O3, GaAs and oxide substrate. In addition, the heat spreader substrate can comprise the impurities of a third material, for example, the third material can be a metal such as Ti, Fe, W, Mo, and V. The third material has a higher mass than the second material so that phonons are scattered more efficiently. The third material is preferably agglomerating at grain boundaries.

The mass of an atom or molecule is typically measured in units of atomic mass (u). The atomic mass of an element, such as W=183.84 u, is usually listed in the periodic table. The mass of molecules, such as SiC= 40.1 u, is determined by summing the atomic masses of all the atoms that make up the molecule.

As discussed above, the heat spreader substrate comprises the third material at a grain boundary between adjacent grains. This further enhances phonon scattering.

### Fifth implementation - growing layer

As discussed above, the growing layer comprises or consists of a monocrystalline material. A monocrystal can be described using a set of crystallographic axes. The orientation of a crystal can be specified by the angles between these axes or by the orientation of specific crystallographic planes or directions relative to an external reference frame.

For example, in cubic crystals, which have three mutually perpendicular crystallographic axes of equal length, orientation might be described by specifying the angle between one of these axes and a reference axis.

The orientation of a crystal is crucial in various scientific and technological applications, such as crystal growth, materials science, semiconductor technology, and studies of crystallography. It plays a significant role in determining the properties and behavior of the crystal in various contexts.

According to fifth implementation of the first solution, an angle between a crystallographic axis of the monocrystalline growing layer and a surface normal of the growing surface is equal to or greater than 0°. Preferably, the angle is equal to or greater than 2° and less than or equal to 8°, preferably less than or equal to 6°. As for example discussed in EP 1 200 651 B1, such an orientation, in particular being greater than 0°, facilitates the growth as a step flow. Notably, EP 1 200 651 B1 relates to a sublimation process. However, as discussed above, step growth can occur in epitaxial process.

Further, the terms "C-face" and "Si-face" are commonly used in the context of crystal growth, particularly in semiconductor materials such as silicon carbide (SiC). These terms refer to specific crystallographic planes on the surface of a semiconductor crystal, which have different properties and reactivities.

The C-face (Carbon face) of a semiconductor crystal, such as SiC, refers to the surface plane predominantly composed of carbon atoms. This surface plane tends to have a higher concentration of carbon atoms, which can influence the surface chemistry and reactivity of the crystal. The C-face may exhibit different surface properties compared to other crystallographic planes, impacting the growth and properties of thin films or other structures deposited on this surface.

The Si-face (Silicon face) of a semiconductor crystal, such as silicon carbide (SiC), refers to the surface plane predominantly composed of silicon atoms. This surface plane tends to have a higher concentration of silicon atoms, which can influence the surface chemistry and reactivity differently from the C-face.

### Sixth implementation - connecting layer

According to a sixth implementation of the first solution, as shown in FIG. 1, the polycrystalline substrate 140 can be bonded to the monocrystalline layer 110 by a connection layer 160. In doing so, a connection must be created that is temperature-stable up to approximately 1500°C to 2300°C.

According to variants, the connecting layer 160 comprises an organic compound as phenolic resin or novolac resin. Additionally or alternatively, the connecting layer 160 can comprises a sintered powder, preferably sintered silicon powder.

Phenol resins, also known as phenolic resins, are a type of thermosetting polymer derived from the reaction between phenol (or substituted phenols) and formaldehyde. A novolac resin, often referred to simply as novolak, is a type of thermosetting resin derived from the condensation reaction between phenol (or substituted phenols) and formaldehyde in the presence of an acid catalyst. Sintering can be used to connect or bond two layers of material together, particularly in the context of powder metallurgy or ceramic processing. In particular, by interlayer sintering a layer of powder is placed between two layers that need to be bonded. When the entire assembly is subjected to sintering conditions, the powder in the interlayer undergoes sintering, forming a bond between the adjacent layers.

Alternatively, the polycrystalline substrate 140 can be hold by an optional substrate holder, for example by additionally providing a connection layer. Notably, for epitaxy no substrate holder is needed. The layered substrate can be directly placed in a pocket of the reactor. This pocket can be seen as a substrate holder.

### Second solution - method for fabricating the layered substrate

The layered substrate as for example shown in FIG. 1 can be fabricated by the following steps:
providing a monocrystalline growing layer 110 with a growing surface 112 for growing the epitaxial layer and an opposing heat spreader facing surface 114 for coupling the growing layer 110 to a heat spreader substrate 140; and
providing the heat spreader substrate 140 with an growing layer facing surface 144 for coupling to the heat spreader facing surface 114 and an opposing mounting surface 142 for mounting the heat spreader 140 to the reactor,
wherein the heat spreader substrate 140 comprises a polycrystalline material having thermally coupled grains 146 that are piled in the direction of growth Y, the piled grains for equalizing hot spots of the reactor thermally coupled to the mounting surface 142, and
connecting the growing layer facing surface 114 to the heat spreader facing surface 144.

For the description of the components is referred to the above discussed first solution and in particular to the implementations.

In particular, the method of fabrication comprises the connecting step as discussed in the sixth implementation. Correspondingly, the method comprises connecting the growing layer facing surface to the heat spreader facing surface by a at least one of a gluing step and a sintering step for forming a connecting layer between the monocrystalline growing layer and the heat spreader substrate.

**Third solution** - **method for growing an** epitaxial layer The layered substrate as for example shown in FIG. 1 can be used in method for growing an epitaxial layer. The growing method comprises the steps:
Mounting a layered substrate according to the first or second solution in a crucible,
Growing, by an epitaxial process, the epitaxial layer on the monocrystalline growing layer.

For the description of the layered substrate is referred to the above discussed first and second solution and in particular to the implementations.

In particular, the method of growing the epitaxial layer comprises the mounting step of mounting the layered substrate to the reactor, for example by an optional substrate holder or a pocket in the reactor as for example described in the sixth implementation of the first solution. For example, the heat spreader substrate is clamped by the substrate holder or hold in a pocket at the end wall of the reactor. Advantageously, the substrate holder comprises graphite.

Further, various epitaxial growth process have been discussed in the section epitaxial growth. For example, the epitaxial layer is grown by the chemical vapor deposition (CVD) process. As discussed above, for epitaxial growth process and in particular for the CVD-process, the growing comprises heating the layered substrate to a temperature of equal to or greater than 1500°C and/or less than or equal to 2300°C.

### Reference Numerals

| **Reference Numeral** | **Description** |
|---|---|
| 110 | monocrystalline growing layer |
| 112 | growing surface |
| 114 | heat spreader facing surface |
| 140 | heat spreader substrate |
| 142 | mounting surface |
| 144 | growing layer facing surface |
| 146 | Grain |
| 148 | Grain boundaries |
| 160 | connecting layer |
| 252, 1252 | Temperature profile |
| 300 | phonon |
| 400 | Epitaxial layer |
| 1212 | Temperature profile |

## Claims

1. Layered substrate for growing an epitaxial layer in a direction of growth (Y) in a reactor, the layered substrate comprising:
a monocrystalline growing layer (110) with a growing surface (112) for growing the epitaxial layer and an opposing heat spreader facing surface (114) for coupling the growing layer (110) to a heat spreader substrate (140); and
the heat spreader substrate (140) with an growing layer facing surface for coupling to the heat spreader facing surface and an opposing mounting surface for mounting the heat spreader substrate (140) to the reactor,
wherein the heat spreader substrate (140) comprises a polycrystalline material having thermally coupled grains (146) that are piled in the direction of growth (Y), the piled grains (146) for equalizing hot spots of the reactor thermally coupled to the mounting surface.

2. Substrate according to claim 1, wherein the monocrystalline growing layer (110) has a thickness in the direction of growth (Y) of equal to or greater than 10 µm and/or less than or equal to 100 µm, and/or wherein the heat spreader substrate (140) has a thickness in the direction of growth (Y) of equal to or greater than 250 µm and/or less than or equal to 500 µm,
optionally wherein the layered substrate has a diameter in a radial dimension (r) of equal to or greater than 150 mm preferably 200 mm and/or less than or equal to 300 mm, the radial dimension (r) is perpendicular to the direction of growth (Y).

3. Substrate according to any of the proceeding claims, wherein a median grain diameter, D50, is equal to or greater than 3 µm and/or less than or equal to 80 µm, preferably wherein D50 is equal to or greater than 3 µm and/or less than or equal to 50 µm, optionally wherein a number of grains piled in the heat spreader substrate (140) in the direction of growth (Y) is equal to or greater than 3 and/or less than or equal to 163, preferably wherein the number is equal to or greater than 5 and/or less than or equal to 163.

4. Substrate according to any of the proceeding claims, wherein the monocrystalline growing layer (110) comprises a first material, the first material being at least one of Si, SiC, AIN, GaN, AlGaN, AlInN, and InN, and/or the grains of the heat spreader substrate (140) comprise a second material, the second material being at least one Si, SiC, AIN, GaN, Al2O3 , GaAs and oxide substrate,
optionally wherein the second material is identical to the first material and the first material being at least one of Si, SiC, AIN, and GaN, or wherein the first material is different from the second material,
optionally wherein the monocrystalline growing layer (110) consists of the first material.

5. Substrate according to any of the proceeding claims, wherein the heat spreader substrate (140) comprises a third material, the third material being a metal, preferably, wherein the third material being at least one of Ti, Fe, W, Mo, and V.

6. Substrate according to any of the proceeding claims, wherein the grains of the heat spreader substrate (140) comprise a second material and the heat spreader substrate (140) comprises a third material, the third material having a higher a higher mass than the second material,
optionally wherein the heat spreader layer comprises the third material at a grain boundary between abutting grains,
optionally wherein the second material being at least one Si, SiC, AIN, GaN, Al2O3, GaAs and oxide substrate,
optionally wherein the third material being a metal, preferably, wherein the third material being at least one of Ti, Fe, W, Mo, and V.

7. Substrate according to any of the proceeding claims, wherein the heat spreader substrate (140) comprises a concentration of impurities, wherein the concentration is equal to or greater than 5 ppm and/or less than or equal to 100 ppm,
optionally wherein the impurities comprise a third material being a metal, preferably, wherein the third material being at least one of Ti, Fe, W, Mo, and V and agglomerating at grain boundaries.

8. Substrate according to any of the proceeding claims, wherein an angle between a crystallographic axis of the monocrystalline growing layer (110) and a surface normal of the growing surface (112) is equal to or greater than 0° and/or less than or equal to 8°, preferably the angle is equal to or greater than 2° and/or less than or equal to 6°.

9. SiC-Substrate according to any of the proceeding claims, wherein the growing surface (112) comprises a silicon face, Si-face, preferably the growing surface is a Si-face.

10. Method for fabricating a layered substrate for growing an epitaxial layer in a direction of growth (Y) in a reactor, the method comprises the steps of:
providing a monocrystalline growing layer (110) with a growing surface (112) for growing the epitaxial layer and an opposing heat spreader facing surface (114) for coupling the growing layer to a heat spreader substrate (140); and
providing the heat spreader substrate (140) with a growing layer facing surface (142) for coupling to the heat spreader facing surface (114) and an opposing mounting surface (142) for mounting the heat spreader to the reactor,
wherein the heat spreader substrate (140) comprises a polycrystalline material having thermally coupled grains (146) that are piled in the direction of growth (Y), the piled grains (146) for equalizing hot spots of the reactor thermally coupled to the mounting surface (142),
connecting the growing layer facing surface (144) to the heat spreader facing surface (114).

11. Method according to claim 10, wherein the growing layer facing surface (144) is connected to the heat spreader facing surface (114) by a at least one of a gluing step and a sintering step for forming a connecting layer (160) between the monocrystalline growing layer (110) and the heat spreader substrate (140).

12. Method for growing an epitaxial layer in a direction of growth (Y), the method comprising the steps of:
Mounting a layered substrate according to any of claims 1 to 10 or a layered substrate fabricated according to the method of claims 11 to 12 in a reactor,
Growing, by an epitaxy process, the epitaxial layer on the monocrystalline growing layer (110).

13. Method according to claim 12 wherein
the mounting surface (142) of the heat spreader substrate (140) is mounted to the reactor.

14. Method according to any of claims 12 to 13, wherein
the epitaxial layer is grown by chemical vapor deposition, optionally wherein growing comprises heating the layered substrate to a temperature of equal to or greater than 1500°C and/or less than or equal to 2000°C.
